(19) Europäisches Patentamt
European Patent Office
Office européen des brevets

(11) **EP 2 442 440 B1**

(12) **EUROPEAN PATENT SPECIFICATION**

(45) Date of publication and mention
of the grant of the patent:
**15.06.2016   Bulletin 2016/24**

(51) Int Cl.:
***H03F 1/02*** *(2006.01)*

(21) Application number: **10290550.2**

(22) Date of filing: **13.10.2010**

(54) **Control unit for a power amplifier and method of operating a control unit for a power amplifier**

Steuerungseinheit für einen Leistungsverstärker und Verfahren zum Betrieb einer Steuerungseinheit für einen Leistungsverstärker

Unité de commande pour un amplificateur de puissance et procédé de fonctionnement d'une unité de commande pour un amplificateur de puissance

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**18.04.2012   Bulletin 2012/16**

(73) Proprietor: **ALCATEL LUCENT**
**92100 Boulogne-Billancourt (FR)**

(72) Inventors:
• **Yu, Xin**
**70435 Stuttgart (DE)**
• **Bohn, Thomas**
**70372 Stuttgart (DE)**

• **Haslach, Christoph, Dr.**
**70178 Stuttgart (DE)**
• **Luz, Gerhard**
**74321 Bletighelm-Bissingen (DE)**

(74) Representative: **Wetzel, Emmanuelle et al**
**Alcatel-Lucent Deutschland AG**
**Intellectual Property Business Group**
**70430 Stuttgart (DE)**

(56) References cited:
**EP-A1- 2 226 932        US-A- 6 028 486**
**US-A1- 2004 061 555    US-A1- 2007 223 360**
**US-B1- 6 556 629        US-B1- 6 677 819**
**US-B2- 6 492 867**

**Description**

Field of the invention

The invention relates to a method of operating a control unit for controlling an operation of a power amplifier.
The invention further relates to a control unit for controlling an operation of a power amplifier.

Background

Power amplifiers are e.g. used in radio frequency communications systems for amplifying radio frequency signals, which are to be transmitted by an antenna over an air interface to one or more receivers.
EP 2 226 932 A1 discloses a power amplifier system.
It is an object of the present invention to provide an improved method of operating a control unit and an improved control unit which enable a more efficient operation of a power amplifier for radio frequency signals and which enable an increased flexibility as compared to conventional systems.

Summary

According to the present invention, regarding the above mentioned method of operating a control unit, this object is achieved by the feature combination of claim 1.
The inventive method advantageously considers that the radio frequency signal to be amplified by said power amplifier may be obtained from a plurality of input signals, and by proposing to determine said control signal depending on said at least two input signals, an increased efficiency for the operation of the power amplifier is achieved.
By deriving the control signal for influencing a supply voltage of said power amplifier from said at least two input signals, the inventive principle enables to efficiently obtain a control signal suitable for controlling the supply voltage of said power amplifier. Thus, it is possible to adapt the supply voltage of the power amplifier to any alteration of the radio frequency signal, which depends on said plurality of input signals.
The inventive principle may be considered as an extension to the known principle of envelope-tracking amplifiers, which determine an envelope signal of the radio frequency signal to be amplified, and which control the voltage supply to the power amplifier depending on said envelope signal. However, this conventional technique disadvantageously only works with RF signals obtained from a single input signal which is to be upconverted to a single RF center frequency in the RF signal, because with multiple input signals or a single input signal which is to be upconverted to different RF center frequencies in the RF signal with a comparatively large frequency spacing ("fragmented bands"), signal processing constellations may occur which cannot be handled by conventional envelope tracking systems due to their limitations regarding an operation bandwidth of the supply voltage or the control signal for the supply voltage, respectively.
Particularly, in such cases, where different possible desired values for a frequency spacing between signal components of said RF input signal may occur, which are associated with said input signals, a maximum operating bandwidth of conventional envelope tracking systems may be exceeded if the control signal for the envelope tracking module is processed according to prior art.
Thus, the inventive principle advantageously enables to provide the power amplifier with a reliable control signal for influencing the supply voltage of the power amplifier in such cases where there are a plurality of input signals, which may also have a varying frequency spacing with reference to their upconverted state, i.e. their target frequency range in the radio frequency signal to be amplified.
According to a preferred embodiment, at least two of said input signals are shifted to an intermediate frequency, IF, range, whereby at least two IF input signals are obtained. This embodiment advantageously enables an improved signal processing by the inventive digital signal processing means for deriving the control signal that is used for influencing the supply voltage of said power amplifier.
According to a further, particularly preferred, embodiment, said IF input signals are added to obtain an IF sum signal, and said control signal is determined depending on an absolute value of said IF sum signal. This embodiment of deriving a control signal for controlling the supply voltage of said power amplifier is particularly preferred for situations in which a desired frequency spacing of the input signals, when being transformed to a passband range in the radio frequency signal, is in a value range which is similar to the frequency range of the input signals, i.e. the bandwidth of the input signals.
In this case, the absolute value of said IF sum signal is basically identical with the envelope signal of the radio frequency signal and thus enables an efficient envelope tracking operation of the power amplifier.
Advantageously, said control signal is determined depending on a sum of absolute values of said at least two input signals. I.e., the present embodiment does not derive said control signal as an envelope signal in a strictly mathematical sense. The present embodiment rather first determines absolute values of each input signal,

preferably in baseband, because according to a preferred embodiment, said input signals may be baseband signals. After that, the absolute values of said input signals are added to derive the inventive control signal for controlling the supply voltage of said power amplifier. According to applicant's analysis, this embodiment achieves a sufficient precision regarding an efficient control of said power amplifier while at the same time enabling to process input signals, which have comparatively large desired frequency spacings in the target frequency range of the RF signal that may well exceed the bandwidth of the input signals by a factor of ten or even more.

That is, the present embodiment advantageously enables to process multiple different input signals which may have target bandpass frequency ranges in the radio frequency signal that may differ by some ten MHz up to various hundred MHz. This advantageously enables to simultaneously process various input signals according to different communications standards, which have completely different target frequency ranges, with only one power amplifier.

For instance, the first input signal may have a target frequency range in the radio frequency signal of about 2.1 GHz, and the second input signal may have a target frequency range in the radio frequency signal of about 2.6 GHz, both input signals being baseband signals with a respective bandwidth of some MHz, i.e. ten MHz. By employing the principle as defined by the present embodiment, both input signals may simultaneously be processed by the digital signal processing means. Further, by deriving the control signal depending on said sum of said respective absolute values of the input signals, a reliable control of the supply voltage for the power amplifier may be obtained, although the desired frequency spacing of said input signals within the radio frequency signal is comparatively large.

According to a further embodiment, said control signal is determined

a) depending on said absolute value of said IF sum signal, if a desired frequency spacing between signal components of said RF input signal, which are associated with said input signals, is below a predetermined threshold, and

b) depending on said sum of absolute values of said at least two input signals, if said desired frequency spacing is above or equal to said predetermined threshold.

The predetermined threshold value for deciding which algorithm to employ for deriving the control signal according to the present embodiment may depend on an operating bandwidth of an envelope tracking module, i.e. a voltage supply system that is employed to provide a controllable supply voltage to the power amplifier. Said predetermined threshold value may alternatively or in addition depend on a bandwidth of the input signals.

The aforementioned embodiment, where said control signal is determined depending on a sum of absolute values of said at least two input signals, does not rely on an intermediate frequency (IF) signal processing to derive the control signal. It rather directly processes the input signals, which - according to a further preferred embodiment - are digital baseband signals. This variant of deriving the control signal is, inter alia, preferred for excessively large frequency spacings which may even range up to several GHz.

As already stated above, according to a further preferred embodiment, the input signals are digital baseband signals. With this embodiment, the determination of said control signal depending on a sum of absolute values of said at least two input signals - as proposed by a further embodiment - is particularly efficient, because only baseband signals have to be processed during determining the absolute values of the input signals. Hence, a comparatively low operating frequency range of the involved signal processing components (i.a. for controlling the PA's supply voltage) is required, although a frequency spacing of the upconverted representations of said processed input signals may well exceed some tens or even hundreds of MHz.

According to a further embodiment, it is also possible to provide only one input signal, multiple "instances" of which are upconverted to different frequency ranges, i.e. center frequencies, in the RF signal. Thus, the RF signal obtained according to the embodiments comprises multiple representations of the same input signal, said multiple representations being arranged at different center frequencies in the RF signal. In this case, the multiple representations of the single input signal are considered to constitute the at least two input signals in the sense of the embodiments. The above explained advantages of the comparatively low operating frequency range of the involved signal processing components, i.a. for controlling the PA's supply voltage, also apply for this embodiment, where multiple instances of the same input signal are processed to obtain said RF signal According to a further embodiment, for configurations with extremely large frequency spacings, several local oscillators may be employed to upconvert the different input signals by means of a respective dedicated upconversion path, and the upconverted input signals are later on added to obtain said radio frequency signal to be amplified. However, the control signal for controlling the supply voltage of the power amplifier may advantageously be directly derived from the digital input signals, i.e. depending on a sum of absolute values of said at least two input signals.

Although the aforementioned embodiments primarily refer to signal processing scenarios employing two input signals, the inventive principle may also be applied to signal processing situations in which more than two input signals are present.

A further preferred embodiment proposes to add said IF input signals to obtain an IF sum signal, to convert said IF sum signal by means of a digital to analog, D/A, converter to an analog signal, and to upconvert said analog signal by multiplying it with a local oscillator signal to obtain said RF signal, which is to be amplified by the power amplifier controlled according to the embodiments.

A further solution to the object of the present invention is given by a control unit according to claim 7.

The digital signal processing means of the control unit may e.g. comprise a microcontroller and/or a digital signal processor (DSP). The digital signal processing means may also comprise a programmable logic module such as an FPGA (field programmable gate array) or an application specific integrated circuit (ASIC).

According to an advantageous embodiment, the digital signal processing means of the control unit may also be combined with signal processing means that are employed by the power amplifier or a transmitter comprising said power amplifier, respectively. For instance, such signal processing means may be provided to convert said input signals from a digital domain to the analog domain and may further provide local oscillator means for upconverting an obtained analog signal to the desired radio frequency range, whereby the radio frequency signal to be amplified by the power amplifier is obtained.

According to a further preferred embodiment, said digital signal processing means are configured to shift at least two of said input signals to an intermediate frequency range, whereby at least two IF input signals are obtained. The respective frequency shifts for shifting the input signals into the IF frequency ranges are preferably determined depending on a desired frequency spacing of the corresponding upconverted input signals within the radio frequency signal.

According to a particularly preferred embodiment, said digital signal processing means are configured to add said IF input signals to obtain an IF sum signal, and to determine said control signal depending on an absolute value of said IF sum signal.

Advantageously, said digital signal processing means are configured to determine said control signal depending on a sum of absolute values of said at least two input signals. This is particularly beneficial for comparatively large values of a desired frequency spacing of the input signals within the radio frequency signal.

According to a further preferred embodiment, said digital signal processing means are configured to determine said control signal

a) depending on said absolute value of said IF sum signal, if a desired frequency spacing between signal components of said RF input signal, which are associated with said input signals, is below a predetermined threshold, and

b) depending on said sum of absolute values of said at least two input signals, if said desired frequency spacing is above or equal to said predetermined threshold.

Advantageously, the inventive digital signal processing means of the control unit are configured to provide a respective functionality for performing several embodiments of the present invention (i.e., alternatives a), b) listed above), which enables to dynamically choose the respective algorithm for obtaining a control signal for influencing the supply voltage of said power amplifier. Thus, the control unit may easily be reconfigured depending on a number of input signals to be processed and/or a respective frequency spacing for said input signals within the radio frequency signal.

Brief description of the figures

Further features, aspects and advantages of the present invention are given in the following detailed description with reference to the drawings in which:

Figure 1     depicts a simplified block diagram of an amplifier system comprising a control unit according to an embodiment,

Figure 2     depicts a signal flow diagram according to a further embodiment,

Figure 3     depicts a signal flow diagram according to a further embodiment,

Figure 4     depicts a signal flow diagram according to a further embodiment, and

Figure 5     depicts frequency components of an RF signal as obtained according to a further embodiment.

Description of the embodiments

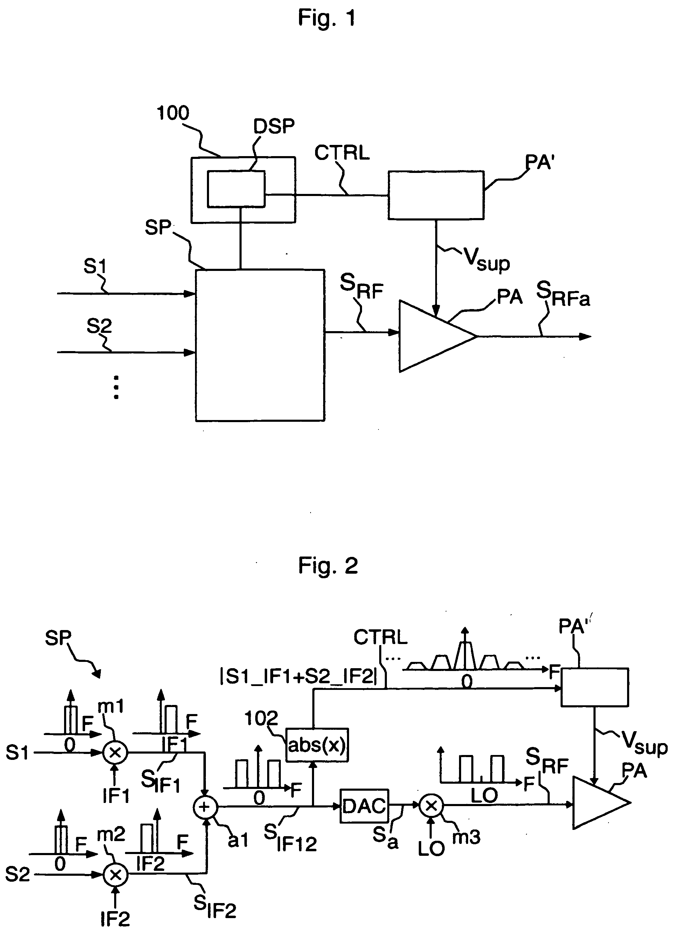

Figure 1 depicts a power amplifier system comprising a power amplifier PA configured to amplify a radio frequency signal $S_{RF}$ that is fed to an input of said power amplifier PA. Correspondingly, at an output of the power amplifier PA, an amplified radio frequency signal $S_{Rfa}$ is obtained.

The power amplifier PA may e.g. be employed in wireless communications systems such as base stations of cellular communications networks or wireless transceivers of mobile terminals and the like. The field of application of the power amplifier PA however, is not limited to wireless applications. The power amplifier PA may rather also be used for wired communication systems, wherein radio frequency signals are to be amplified.

The power amplifier PA comprises a power amplifier supply voltage module PA' which is configured to modify a supply voltage Vsup that is applied to the power amplifier PA. By controlling the supply voltage Vsup supplied to the power amplifier PA, an operating efficiency of the power amplifier PA may be controlled in a per se known manner.

For instance, conventional systems also denoted as "envelope tracking" amplifiers comprise a control of the supply voltage vsup for the power amplifier PA depending on an envelope signal of a radio frequency signal $S_{RF}$ to be amplified. However, the conventional envelope tracking techniques cannot reliably be applied to operating scenarios, where more than one input signal is upconverted to obtain the radio frequency signal $S_{RF}$ with certain value ranges of the desired frequency spacing.

Thus, according to an embodiment, a control signal CTRL for modifying the supply voltage Vsup is determined depending on a plurality of input signals S1, S2, ... which are forwarded to a signal processing unit SP. The signal processing unit SP performs per se known signal processing techniques to transform the various input signals S1, S2, ... into the radio frequency signal $S_{RF}$.

Advantageously, a control unit 100 for controlling the operation of the power amplifier PA and its supply voltage module PA' is provided. The control unit 100 comprises digital signal processing means DSP which derive the control signal CTRL depending on said input signals S1, S2,

By deriving the control signal CTRL depending on said input signals S1, S2, .., an improved supply voltage control for the power amplifier PA as compared to conventional envelope tracking systems may be obtained, especially in such cases, where more than one input signal S1, S2, ... is to be processed to obtain said RF signal $S_{RF}$. Moreover, the signal processing structure according to the embodiments is capable of providing an efficient supply voltage control even in such cases, where excessively large frequency spacings for the input signals S1, S2, ... to be upconverted to obtain several radio frequency signal $S_{RF}$ are to be achieved.

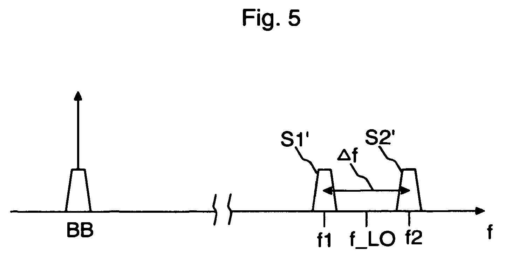

Figure 5 depicts various signals on a frequency axis f i.a. for illustrating the term "frequency spacing" as used by the present embodiments.

According to a preferred embodiment, the input signals S1, S2 to be processed by the components SP, PA (Figure 1) are baseband signals, which are correspondingly arranged in a baseband frequency range BB as depicted by Figure 5. During the signal processing within component SP, the input signals S1, S2 are, inter alia, upconverted in a per se known manner, e.g. by multiplying with a local oscillator signal having a frequency f_LO. Thus, as a result of the upconversion process, signal components S1', S2' are obtained at an output of block SP, which correspond to the input signals S1, S2. I.e., the signal components S1', S2' are upconverted representations of the input signals S1, S2.

Depending on an application scenario and corresponding details of the signal processing performed within block SP, a frequency spacing Δf between the center frequencies f1, f2 of the signal components S1', S2' may vary.

For instance, in a first application scenario, the maximum bandwidth of the input signals in the baseband range may amount to about 5 MHz, whereas a desired frequency spacing Δf of the modulated (i.e., upconverted) signal components S1', S2' may be equal to about 30 MHz.

In a second application scenario, the bandwidth of the input signals in the baseband range may amount to about 5 MHz, whereas a desired frequency spacing Δf of the modulated (i.e., upconverted) signal components 31', S2' exceeds 30 MHz. For example, the desired frequency spacing Δf may be some 100 MHz.

Further application scenarios with even larger frequency spacings Δf up to the GHz range are also possible, as well as two or more input signals S1, S2, .. having other (smaller or larger) bandwidth than the exemplary number of 5 MHz mentioned above. Moreover, much higher target frequency ranges of e.g. tens of GHz are also possible for the input signals S1, S2.

The embodiments of the present invention advantageously enable to provide a precise and stable control of the power amplifier PA or its supply voltage Vsup, respectively, for all of the aforedescribed application scenarios. By employing the principle according to the embodiments further explained below with reference to Figures 2 to 4, a wide number and/or variety of different input signals S1, S2, and/or different desired frequency spacings Δf may be covered while only requiring a single power amplifier PA the supply voltage vsup of which is controlled according to the embodiments by the control unit 100 (Figure 1).

Figure 2 depicts a signal flow according to a particularly preferred embodiment. Two input signals S1, S2, which may be digital baseband signals, are provided to the signal processing unit SP.

The first input signal S1 is shifted to an intermediate frequency range IF1 by multiplying the input signal S1 with a first intermediate frequency oscillator signal IF1 by means of a first multiplier m1. At an output of said multiplier m1, a first intermediate frequency signal $S_{IF1}$ is obtained. Likewise, the second input signal S2 is shifted to a second intermediate frequency range IF2 by multiplication with a second intermediate frequency oscillator signal IF2, which is performed by a second multiplier m2. Thus, at an output of said second multiplier m2, a second intermediate frequency signal $S_{IF2}$ is obtained.

The intermediate frequency signals $S_{IF1}$, $S_{IF2}$ are added by a first adder a1 to obtain an intermediate frequency sum signal $S_{IF12}$. Said IF sum signal $S_{IF12}$ is forwarded to a digital to analog converter DAC which transforms the IF sum signal $S_{IF12}$ from the digital domain to the analog domain, whereby an analog signal $S_a$ is obtained at an output of the DAC. The analog signal Sa is multiplied with a local oscillator signal LO by means of a third multiplier m3, whereby a radio frequency signal $S_{RF}$ is obtained at an output of the multiplier m3.

The aforementioned signal processing steps accomplished by the components m1, m2, a1, DAC, m3 can e.g. be provided in a per se known manner by the signal processing unit SP.

According to the present embodiment, said radio frequency signal $S_{RF}$ is amplified by the power amplifier PA, which is supplied with a variable supply voltage Vsup.

A control signal CTRL for controlling the value of the supply voltage vsup by means of said voltage supply means PA' is determined by the digital signal processing means DSP of the control unit 100 (figure 1) according to an embodiment.

Presently, the control signal CTRL is determined depending on an absolute value of the IF sum signal $S_{IF12}$. More precisely, the absolute value of the IF sum signal $S_{IF12}$ is employed as said control signal CTRL. The absolute value of the IF sum signal $S_{IF12}$ is evaluated by the block 102, a functionality of which may be integrated into the digital signal processing means DSP of the control unit 100.

The determination of the control signal CTRL according to the embodiment depicted by Figure 2 advantageously enables a precise supply voltage control of the power amplifier PA, which depends on the absolute value of the IF sum signal $S_{IF12}$, which, in turn, corresponds with an envelope signal of the radio frequency signal $S_{RF}$ to be amplified by the power amplifier PA.

As such, the embodiment depicted by Figure 2 resembles an envelope tracking power amplifier with the deciding difference that said control signal CTRL is directly and efficiently obtained from the digital signal processing means DSP depending on said input signals S1, S2, or the intermediate frequency sum signal $S_{IF12}$, respectively, in contrast to calculating an envelope signal of said radio frequency signal $S_{RF}$ which requires a more complex signal processing.

The embodiment according to Figure 2 is particularly preferred for such signal processing scenarios, in which a desired frequency spacing $\Delta f$ (Figure 5) of the different input signals S1, S2, ... within the radio frequency signal $S_{RF}$ is in the range of the bandwidth of the signals S1, S2, ..., said desired frequency spacing $\Delta f$ being much smaller than the frequency of the local oscillator LO.

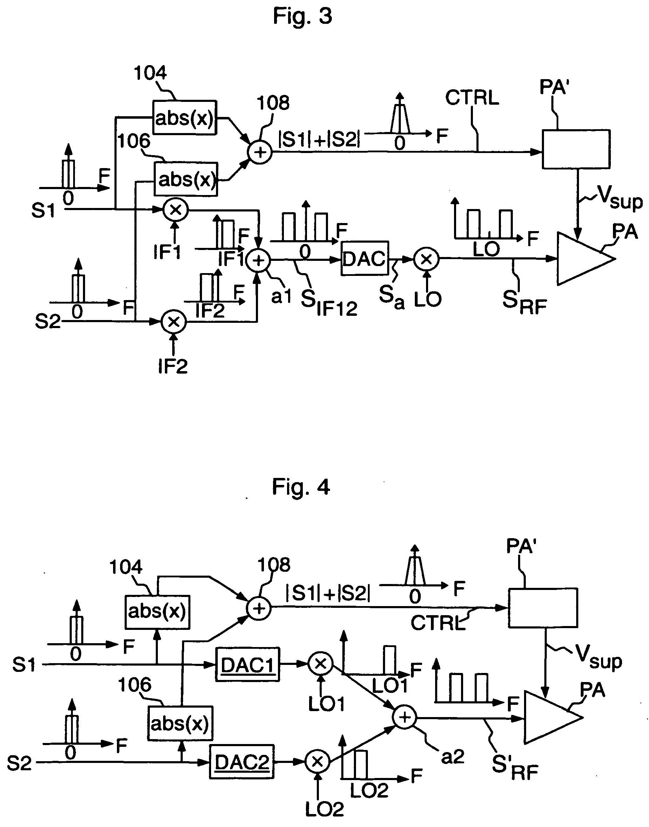

Figure 3 depicts a signal flow according to a further embodiment. In contrast to evaluating an absolute value of the intermediate frequency sum signal, the embodiment according to Figure 3 proposes to evaluate said control signal CTRL as a sum of the absolute values of the input signals S1, S2. That is, an absolute value abs(S1) of the first input signal S1 is obtained by the function block 104 and an absolute value abs(S2) of the second input signal S2 is obtained by the function block 106 of Figure 3. The absolute values of the input signals S1, S2 are added by means of adder 108 to obtain said control signal CTRL. In analogy to the embodiment according to Figure 2, the supply voltage Vsup for the power amplifier PA is again determined depending on said control signal CTRL.

However, the present embodiment depicted by Figure 3 does not provide for evaluating said control signal CTRL as an envelope signal of the radio frequency signal $S_{RF}$ in a strictly mathematical sense. The control signal CTRL is rather obtained as the sum of the absolute values of the input signals S1, S2, which may also be denoted as "beat signal", which according to applicant's analysis represents a proper substitute for the envelope signal as far as controlling the power amplifier PA is concerned.

The embodiment according to Figure 3 is particularly preferred for such signal processing scenarios, wherein a desired frequency spacing $\Delta f$ of the input signals S1, S2 - when being transformed to the radio frequency signal $S_{RF}$ - is comparatively large, e.g. larger than for the situation according to Figure 2. For instance, the embodiment according to Figure 3 may advantageously be employed if the frequency spacing $\Delta f$ between the input signals S1, S2 in their upconverted state within the radio frequency signal $S_{RF}$ exceeds the bandwidth of the input signals S1, S2 ... by a factor of ten or more.

Figure 4 depicts a further embodiment, wherein the control signal CTRL again is obtained as a sum of the absolute values of the input signals S1, S2. In contrast to the signal upconversion path of Figure 3, which comprises the components DAC, LO, the embodiment according to Figure 4 provides two dedicated upconversion paths for the respective input signals S1, S2. That is, the first input signal S1 is converted to the analog domain by a first digital to analog converter DAC1. An output signal of said first DAC1 is upconverted by a multiplier, a second input of which is supplied with a first local oscillator signal LO1. At an output of said multiplier, a corresponding first radio frequency signal, which comprises the input signal S1 in its upconverted state, is obtained.

The second input signal S2 is converted to the analog domain by a second DAC2, an output signal of which is upconverted by the second local oscillator LO2. An output of said second local oscillator LO2 is supplied to the adder a2 for addition with the output of the first local oscillator LO1, whereby, at an output of said adder a2, a radio frequency signal S'$_{RF}$ is obtained for amplification by means of the power amplifier PA.

In contrast to the embodiments according to Figure 2, Figure 3, the embodiment according to Figure 4 thus provides two different upconversion paths for the respective input signals S1, S2, which may be required for signal processing scenarios that require a frequency spacing $\Delta f$ between the upconverted spectral ranges S1', S2' corresponding with the input signals S1, S2 that exceeds several hundred MHz or even 1 GHz.

The embodiments explained above with reference to the figures advantageously provide for an efficient determination of a control signal CTRL for influencing a supply voltage Vsup for the power amplifier PA. By continuously adapting the supply voltage Vsup of the power amplifier PA to the signals S1, S2 to be amplified, a power efficiency of the power amplifier PA may advantageously be increased.

According to a further advantageous embodiment, the functionalities according to the various signal processing scenarios of Figure 2, 3, 4 are all together implemented in the digital signal processing means DSP (Figure 1) and may selectively be employed depending on the input signals S1, S2, ... and their spectral properties and a desired frequency spacing for said input signals.

Preferably, with the embodiment according to Figure 2, the functionality of block 102 is implemented by the digital signal processing means DSP of the control unit 100, whereas the further signal processing realized by the components m1, m2, a1, DAC, LO may be provided by a conventional signal processing path SP.

Regarding the embodiment according to Figure 3, the functionality of the function blocks 104, 106, 108 may be implemented within the digital signal processing means DSP of the control unit 100, whereas further signal processing realized by the components IF1, IF2, a1, DAC, LO may again be provided by conventional signal processing path SP. With reference to the embodiment according to Figure 4, the functionality of the function blocks 104, 106, 108 may be implemented within the digital signal processing means DSP of the control unit 100, whereas the further signal processing provided by the digital to analog converters DAC1, DAC2 and the local oscillators LO1 LO2, and the adder a2 may again be provided by a per se known signal processing path SP.

Advantageously, the functionality of the signal processing path SP and the digital signal processing means DSP may also be combined in one signal processing unit. Thus, existing power amplifier systems may be upgraded by extending existing signal processing capabilities by the principle according to the embodiments.

According to a further aspect, the embodiment explained above with reference to Figure 2 may advantageously be employed if a desired frequency spacing $\Delta f$ satisfies the following relation:

(fs1+fs2) < 2*$\Delta f$ << flo, wherein fs1, fs2 represent a respective measure for the bandwidth of the input signals S1, S2, .. to be processed, wherein $\Delta f$ represents the frequency spacing, and wherein flo represents a modulation frequency employed by the local oscillator LO to transform the analogue signal Sa to the radio frequency range, i.e. to obtain the radio frequency signal S$_{RF}$.

As an example, the following values may be employed according to an embodiment:

$$\texttt{fs1 = 5 MHz, fs2 = 10 MHz, } \Delta\texttt{f = 30 MHz, flo = 2.14 GHz}$$

According to a further aspect, the embodiment explained above with reference to Figure 4 is advantageously employed if the following relation is satisfied:

$$\texttt{(fs1, fs2) << } \Delta\texttt{f << flo,}$$

wherein fs1 = 20 MHz, fs2 = 10 MHz, $\Delta f$ = 500 MHz, flo1 = 2.14 GHz, flo2 = 2.64 GHz, wherein flo1 is a frequency of said first local oscillator LO1, and wherein flo2 is a frequency of said second local oscillator LO2.

According to a further embodiment, the differentiation between applying the algorithm for determining the control signal CTRL according to Figure 2 or Figure 3 may be made depending on whether the desired $\Delta f$ frequency spacing exceeds a predetermined threshold value or not. For instance, the method according to Figure 2 may be applied, if the desired frequency spacing $\Delta f$ does not exceed a predetermined threshold value, whereas the method according to Figure 3 may be applied, if the desired frequency spacing $\Delta f$ equals or exceeds a predetermined threshold value.

The application of the inventive principle advantageously enables to implement a single RF transmitter comprising the power amplifier PA operated according to the embodiments for handling a plurality of different frequency bands, i.e. input signals S1, S2, ... with different frequency spacings $\Delta f$ and different frequency ranges regarding their upconverted representations in the radio frequency signal.

Instead of being required to implement one complete transmitter including a dedicated power amplifier for each frequency band (input signal) to be processed, only one transmitter with one single power amplifier PA operated according to the embodiments may be provided, which advantageously handles a plurality of input signals.

According to a further embodiment, it is also possible to provide only one input signal S1, multiple "instances" of which are upconverted to different frequency ranges, i.e. center frequencies, in the RF signal $S_{RF}$. This scenario may e.g. be established by defining S2 = S1. Thus, the RF signal $S_{RF}$ obtained according to the embodiments comprises multiple representations of the same input signal S1 (=S2), said multiple representations being arranged at different center frequencies in the RF signal. In this case, the multiple representations of the single input signal are considered to constitute the at least two input signals in the sense of the embodiments. The above explained advantages of the comparatively low operating frequency range of the involved signal processing components 102, 104, 106, PA', i.a. for controlling the PA's supply voltage, also apply for this embodiment, where multiple instances of the same input signal are processed to obtain said RF signal.

The description and drawings merely illustrate the principles of the invention. It will thus be appreciated that those skilled in the art will be able to devise various arrangements that, although not explicitly described or shown herein, embody the principles of the invention and are included within its spirit and scope. Furthermore, all examples recited herein are principally intended expressly to be only for pedagogical purposes to aid the reader in understanding the principles of the invention and the concepts contributed by the inventor(s) to furthering the art, and are to be construed as being without limitation to such specifically recited examples and conditions. Moreover, all statements herein reciting principles, aspects, and embodiments of the invention, as well as specific examples thereof, are intended to encompass equivalents thereof.

The functions of the various elements shown in the FIGs., including any functional blocks labeled as 'processors', may be provided through the use of dedicated hardware as well as hardware capable of executing software in association with appropriate software. When provided by a processor, the functions may be provided by a single dedicated processor, by a single shared processor, or by a plurality of individual processors, some of which may be shared. Moreover, explicit use of the term 'processor' or 'controller' should not be construed to refer exclusively to hardware capable of executing software, and may implicitly include, without limitation, digital signal processor (DSP) hardware, network processor, application specific integrated circuit (ASIC), field programmable gate array (FPGA), read only memory (ROM) for storing software, random access memory (RAM), and non volatile storage. Other hardware, conventional and/or custom, may also be included. Similarly, any switches shown in the FIGS. are conceptual only. Their function may be carried out through the operation of program logic, through dedicated logic, through the interaction of program control and dedicated logic, or even manually, the particular technique being selectable by the implementer as more specifically understood from the context.

It should be appreciated by those skilled in the art that any block diagrams herein represent conceptual views of illustrative circuitry embodying the principles of the invention. Similarly, it will be appreciated that any flow charts, flow diagrams, state transition diagrams, pseudo code, and the like represent various processes which may be substantially represented in computer readable medium and so executed by a computer or processor, whether or not such computer or processor is explicitly shown.

**Claims**

1. Method of operating a control unit (100) for controlling an operation of a power amplifier (PA), wherein said power amplifier (PA) is configured to amplify a radio frequency, RF, signal ($S_{RF}$) that is obtained from at least two input signals (S1, S2), wherein a control signal (CTRL) for influencing a supply voltage (Vsup) of said power amplifier (PA) is determined by digital signal processing means (DSP) of said control unit (100) depending on said at least two input signals (S1, S2), wherein said control signal (CTRL) is determined depending on a sum of absolute values of said at least two input signals (S1, S2).

2. Method according to claim 1, wherein at least two of said input signals (S1, S2) are shifted to an intermediate frequency, IF, range, whereby at least two IF input signals ($S_{IF1}$, $S_{IF2}$) are obtained.

3. Method according to claim 2, wherein said IF input signals ($S_{IF1}$, $S_{IF2}$) are added to obtain an IF sum signal ($S_{IF12}$), and wherein said control signal (CTRL) is determined depending on an absolute value of said IF sum signal ($S_{IF12}$).

4. Method according to claim 3, wherein said control signal (CTRL) is determined

a) depending on said absolute value of said IF sum signal ($S_{IF12}$), if a desired frequency spacing ($\Delta f$) between

signal components (S1', S2') of said RF input signal ($S_{RF}$), which are associated with said input signals (S1, S2), is below a predetermined threshold, and
b) depending on said sum of absolute values of said at least two input signals (S1, S2), if said desired frequency spacing ($\Delta$f) is above or equal to said predetermined threshold.

5.  Method according to one of the preceding claims, wherein said input signals (S1, S2) are digital baseband signals, and wherein said control signal (CTRL) is determined by means of digital signal processing.

6.  Method according to one of the claims 2 to 6, wherein said IF input signals ($S_{IF1}$, $S_{IF2}$) are added to obtain an IF sum signal ($S_{IF12}$), wherein said IF sum signal ($S_{IF12}$) is converted by means of a digital to analog, D/A, converter (DAC) to an analog signal (Sa), and wherein said analog signal (Sa) is upconverted by multiplying it with a local oscillator signal (LO) to obtain said RF signal ($S_{RF}$).

7.  Control unit (100) for controlling an operation of a power amplifier (PA), wherein said power amplifier (PA) is configured to amplify a radio frequency, RF, signal ($S_{RF}$) that is obtained from at least two input signals (S1, S2), wherein said control unit (100) comprises digital signal processing means (DSP) configured to determine a control signal (CTRL) for influencing a supply voltage (Vsup) of said power amplifier (PA) depending on said at least two input signals (S1, S2), wherein said digital signal processing means (DSP) are configured to determine said control signal (CTRL) depending on a sum of absolute values of said at least two input signals (S1, S2).

8.  Control unit (100) according to claim 7, wherein said digital signal processing means (DSP) are configured to shift at least two of said input signals (S1, S2) to an intermediate frequency, IF, range, whereby at least two IF input signals ($S_{IF1}$, $S_{IF2}$) are obtained.

9.  Control unit (100) according to claim 8, wherein said digital signal processing means (DSP) are configured to add said IF input signals ($S_{IF1}$, $S_{IF2}$) to obtain an IF sum signal ($S_{IF12}$), and to determine said control signal (CTRL) depending on an absolute value of said IF sum signal ($S_{IF12}$).

10. Control unit (100) according to claim 10, wherein said digital signal processing means (DSP) are configured to determine said control signal (CTRL)

    a) depending on said absolute value of said IF sum signal ($S_{IF12}$), if a desired frequency spacing ($\Delta$f) between signal components (S1', S2') of said RF input signal ($S_{RF}$), which are associated with said input signals (S1, S2), is below a predetermined threshold, and
    b) depending on said sum of absolute values of said at least two input signals (S1, S2), if said desired frequency spacing ($\Delta$f) is above or equal to said predetermined threshold.

**Patentansprüche**

1.  Verfahren für den Betrieb einer Steuerungseinheit (100) zur Steuerung einer Operation eines Leistungsverstärkers (Power Amplifier, PA), wobei besagter Leistungsverstärker (PA) konfiguriert ist für das Verstärken des Signals einer Funkfrequenz (Radio Frequency Signal, $S_{RF}$), das erhalten wird von mindestens zwei Eingangssignalen (S1, S2), wobei ein Steuersignal (CTRL) zur Beeinflussung einer Versorgungsspannung (Supply Voltage, Vsup) besagten Leistungsverstärkers (PA) von einem Signalverarbeitungsmittel (DSP) besagter Steuerungseinheit (100) in Abhängigkeit von besagten mindestens zwei Eingangssignalen (S1, S2) bestimmt wird, wobei besagtes Steuersignal (CTRL) in Abhängigkeit von einer Summe obsoleter Werte besagter mindestens zwei Elngangssignale (S1, S2) bestimmt wird.

2.  Verfahren nach Anspruch 1, wobei mindestens zwei der besagten Eingangssignale (S1, S2) in den Bereich einer Zwischenfrequenz (Intermediate Frequency, IF) verschoben werden, wobei mindestens zwei IF-Eingangssignale ($S_{IF1}$, $SS_{IF2}$) erhalten werden.

3.  Verfahren nach Anspruch 2, wobei besagte IF-Eingangssignale ($S_{IF1}$, $S_{IF2}$) hinzugefügt werden, um ein IF-Summensignal ($S_{IF12}$) zu erhalten, und wobei besagtes Steuersignal (CTRL) in Abhängigkeit von einem absoluten Wert besagten IF-Summensignals ($S_{IF12}$) bestimmt wird.

4.  Verfahren nach Anspruch 3, wobei besagtes Steuersignal (CTRL) bestimmt wird

a) in Abhängigkeit von besagtem absolutem Wert besagten IF-Summensignals ($S_{IF12}$), wenn ein erwünschter Frequenzabstand ($\Delta f$) zwischen Signalkomponenten (S1', S2') besagten RF-Eingangssignals ($S_{RF}$), welche mit besagten Eingangssignalen (S1, S2) assoziiert sind, unter einem vordefinierten Grenzwert liegt, und
b) in Abhängigkeit von besagter Summe absoluter Werte besagter mindestens zwei Eingangssignale (S1, S2), wenn besagter erwünschter Frequenzabstand ($\Delta f$) über oder gleich besagtem vordefiniertem Grenzwert liegt.

5. Verfahren nach einem jeglichen der vorangegangenen Ansprüche, wobei besagte Eingangssignale (S1, S2) digitale Basisbandsignale sind und wobei besagtes Steuersignal (CTRL) anhand von digitaler Signalverarbeitung bestimmt wird.

6. Verfahren nach einem jeglichen der Anspruche 2 bis 6, wobei besagte IF-Elngangsslgnale ($S_{IF1}$, $S_{IF2}$) hinzugefügt werden, um ein IF-Summensignal ($B_{IF12}$) zu erhalten, wobei besagtes IF-Summensignal ($S_{IF12}$) anhand eines Digital-Analog-Wandlers (D/A Converter, DAC) in ein analoges Signal (Sa) umgewandelt wird und wobei besagtes analoges Signal (Sa) heraufkonvertiert wird, Indem es mit einem Signal eines lokalen Oszillators (LO) multipliziert wird, um besagtes RF-Signal ($S_{RF}$) zu erhalten.

7. Steuerungseinheit (100) für die Steuerung einer Operation eines Leistungsverstärkers (PA), wobei besagter Leistungsverstärker (PA) konfiguriert ist für das Verstärken des Signals einer Funkfrequenz (Radio Frequency Signal, $S_{RF}$), das erhalten wird von mindestens zwei Eingangssignalen (S1, S2), wobei besagte Steuerungseinheit (100) Mittel für die digitale Signalverarbeitung (Digital Signal Processing, DSP) umfasst, die konfiguriert sind für das Bestimmen eines Steuersignals (CTRL) zur Beeinflussung einer Versorgungsspannung (Vsup) besagten Leistungsverstärkers (PA) in Abhängigkeit von mindestens zwei Eingangssignalen (S1, S2), wobei besagte Mittel zur digitalen Signalverarbeitung (DSP) konfiguriert sind zum Bestimmen besagten Steuersignals (CTRL) in Abhängigkeit von einer Summe obsoleter Werte besagter mindestens zwei Eingengssignale (S1, S2).

8. Steuerungseinheit (100) nach Anspruch 7, wobei besagte Mittel für die Signalverarbeitung (DSP) konfiguriert sind für das Verschieben von mindestens zwei der besagten Eingangssignale (S1, S2) In den Bereich einer Zwischenfrequenz (IF), wobei mindestens zwei IF-Eingangssignals ($S_{IF1}$, $S_{IF2}$) erhalten werden.

9. Steuerungseinheit (100) nach Anspruch 8, wobei besagte Mittel für die digitale Signalverarbeitung (DSP) dafür konfiguriert sind, um besagte IF-Eingangssignale ($S_{IF1}$, $S_{IF2}$) hinzufügen, um ein IF-Summensignal ($S_{IF12}$) zu erhalten und besagtes Steuersignal (CTRL) in Abhängigkeit von einem absoluten Wert besagten IF-Summensignals ($S_{IF12}$) zu bestimmen.

10. Steuerungseinheit (100) nach Anspruch 1, wobei besagte Mittel zur digitalen Signalverarbeitung (DSP) konfiguriert sind für das Bestimmen besagten Steuersignals (CTRL)

a) in Abhängigkeit von besagtem absolutem Wert besagten IF-Summensignals ($S_{IF12}$), wenn ein erwünschter Frequenzabstand ($\Delta f$) zwischen Signalkomponenten (S1', S2') besagten RF-Eingangssignals ($S_{RF}$), welche mlt besagten Eingangssignalen (S1, S2) assoziiert sind, unter einem vordefinierten Grenzwert liegt, und
b) in Abhängigkeit von besagter Summe absoluter Werte besagter mindestens zwei Eingangssignale (S1, S2), wenn besagter erwünschter Frequenzabstand ($\Delta f$) über oder gleich besagtem vordefiniertem Grenzwert liegt.

**Revendications**

1. Procédé de fonctionnement d'une unité de commande (100) pour commander le fonctionnement d'un amplificateur de puissance (PA), ledit amplificateur de puissance (PA) étant configuré pour amplifier un signal de fréquence radio, RF, ($S_{RF}$) qui est obtenu à partir d'au moins deux signaux d'entrée (S1, S2), un signal de commande (CTRL) pour influencer une tension d'alimentation (Vsup) dudit amplificateur de puissance (PA) étant déterminé par des moyens de traitement de signal numérique (DSP) de ladite unité de commande (100) en fonction desdits au moins deux signaux d'entrée (S1, S2), ledit signal de commande (CTRL) étant déterminé en fonction d'une somme de valeurs absolues desdits au moins deux signaux d'entrée (S1, S2).

2. Procédé selon la revendication 1, dans lequel au moins deux desdits signaux d'entrée (S1, S2) sont décalés vers une plage de fréquences intermédiaires, IF, obtenant ainsi au moins deux signaux d'entrée IF ($S_{IF1}$, $S_{IF2}$).

3. Procédé selon la revendication 2, dans lequel lesdits signaux d'entrée IF ($S_{IF1}$, $S_{IF2}$) sont ajoutés pour obtenir un signal de somme IF ($S_{IF12}$), et dans lequel ledit signal de commande (CTRL) est déterminé en fonction d'une valeur absolue dudit signal de somme IF ($S_{IF12}$).

4. Procédé selon la revendication 3, dans lequel ledit signal de commande (CTRL) est déterminé

a) en fonction de ladite valeur absolue dudit signal de somme IF ($S_{IF12}$), si un espacement de fréquences ($\Delta f$) souhaité entre des composantes de signal (S1', S2') dudit signal d'entrée RF ($S_{RF}$), qui sont associées auxdits signaux d'entrée (S1, S2), est inférieur à un seuil prédéterminé, et
b) en fonction de ladite somme de valeurs absolues desdits au moins deux signaux d'entrée (S1, S2), si ledit espacement de fréquences ($\Delta f$) souhaité est supérieur ou égal audit seuil prédéterminé.

5. Procédé selon l'une des revendications précédentes, dans lequel lesdits signaux d'entrée (S1, S2) sont des signaux numériques en bande de base, et dans lequel ledit signal de commanda (CTRL) est déterminé au moyen d'un traitement de signaux numériques.

6. Procédé selon l'une des revendications 2 à 6, dans lequel lesdits signaux d'entrée IF ($S_{IF1}$, $S_{IF2}$) sont ajoutés pour obtenir un signal de somme IF ($S_{IF12}$), ledit signal de somme IF ($S_{IF12}$) étant converti au moyen d'un convertisseur numérique/analogique, N/A, (CNA) en un signal analogique (Sa), et ledit signal analogique (Sa) étant converti à la hausse en le multipliant par un signal d'oscillateur local (LO) pour obtenir ledit signal RF ($S_{RF}$).

7. Unité de commande (100) pour commander le fonctionnement d'un amplificateur de puissance (PA), ledit amplificateur de puissance (PA) étant configuré pour amplifier un signal de fréquence radio, RF, ($S_{RF}$) qui est obtenu à partir d'au moins deux signaux d'entrée (S1, S2), ladite unité de commande (100) comprenant des moyens de traitement de signal numérique (DSP) configurés pour déterminer un signal de commande (CTRL) pour influencer une tension d'alimentation (Vsup) dudit amplificateur de puissance (PA) en fonction desdits au moins deux signaux d'entrée (S1, S2), lesdits moyens de traitement de signal numérique (DSP) étant configurés pour déterminer ledit signal de commande (CTRL) en fonction d'une somme de valeurs absolues desdits au moins deux signaux d'entrée (S1, S2).

8. Unité de commande (100) selon la revendication 7, dans laquelle lesdits moyens de traitement de signal numérique (DSP) sont configurés pour décaler au moins deux desdits signaux d'entrée (S1, S2) vers une plage de fréquences intermédiaires, IF, obtenant ainsi au moins deux signaux d'entrée IF ($S_{IF1}$, $S_{IF2}$).

9. Unité de commande (100) selon la revendication 8, dans laquelle lesdits moyens de traitement de signal numérique (DSP) sont configurées pour ajouter lesdits signaux d'entrée IF ($S_{IF1}$, $S_{IF2}$) pour obtenir un signal de somme IF ($S_{IF12}$) et pour déterminer ledit signal de commande (CTRL) en fonction d'une valeur absolue dudit signal de somme IF ($S_{IF12}$).

10. Unité de commande (100) selon la revendication 10, dans laquelle lesdits moyens de traitement de signal numérique (DSP) sont configurés pour déterminer ledit signal de commande (CTRL)

a) en fonction de ladite valeur absolue dudit signal de somme IF ($S_{IF12}$), si un espacement de fréquences ($\Delta f$) souhaité entre des composantes de signal (S1', S2') dudit signal d'entrée RF ($S_{RF}$), qui sont associées auxdlts signaux d'entrée (S1, S2), est inférieur à un seuil prédéterminé, et
b) en fonction de ladite somme de valeurs absolues desdits au moins deux signaux d'entrée (S1, S2), si ledit espacement de fréquences ($\Delta f$) souhaité est supérieur ou égal audit seuil prédéterminé.

## Fig. 1

## Fig. 2

## Fig. 3

## Fig. 4

## Fig. 5

**EP 2 442 440 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 2226932 A1